# EUROPEAN PATENT SPECIFICATION

(11) **EP 1 430 314 B1**
(45) Date of publication and mention of the grant of the patent: **06.12.2006**
(21) Application number: 02762663.9
(22) Date of filing: 29.08.2002
(51) Int. Cl.: G01R 19/04

(54) **A MINIMUM DETECTOR**
MINIMUM DETEKTOR
DETECTEUR DE VALEUR MINIMALE

(30) Priority: 07.09.2001 EP 01203384
(43) Date of publication of application: 23.06.2004
(73) Proprietor: Koninklijke Philips Electronics N.V., 5621 BA Eindhoven (NL)
(72) Inventor: HEIJNA, Roeland, J., NL-5656 AA Eindhoven (NL); FRAMBACH, Johannes, P., A., NL-5656 AA Eindhoven (NL)
(74) Representative: Duijvestijn, Adrianus Johannes
(86) International application number: PCT/IB2002/003558
(87) International publication number: WO 2003/023416

(56) References cited:
- EP-A- 0 840 432
- WO-A-02/084878
- US-A- 5 614 851

## Description

The invention relates to a minimum detector arrangement comprising a minimum detector for detecting a minimum value of an input signal and generating a first output signal indicative for an approximation of the minimum value of the input signal.

Extreme value detectors and, especially, maximum value detectors are widely used in modem technology as in measurement and data acquisition systems. When possible, a minimum value detector can be realized with an inverter and a maximum detector said inverter inverting a signal whose minimum value has to be determined. In this way the minimum value of a signal is determined in an indirect way by first inverting the input signal and subsequently determining the maximum of the inverted signal. But there are situations when this is not possible and a minimum detector has to be implemented in a direct way. It is further observed that the signal whose minimum or maximum value has to be determined could be a voltage, a current, a charge.

A minimum current detector comprises a differential comparator having an inverting input (-) and a non-inverting input (+) and an output (out). As long as a voltage (Vin) applied to the non-inverting input (+) is less then a reference voltage (Vref) applied to the inverting input (-) the output is in an OFF state i.e. an output current of the comparator is significantly zero. When the voltage applied to the non-inverting input (+) is larger that the reference voltage i.e. the comparator is in an ON state, there is an output current indicating that the comparator is in the ON state. When the input signal (Iin) changes very quickly, i.e. when there is a train of high frequency impulses, the detection of a minimum value of the input signal must be made very fast and in the same time with a maximum accuracy. Furthermore, edges of the input pulses must be very sharp in order to avoid an uncertainty situation when the input voltage (Vin) is almost equal to the reference voltage and the output of the comparator could oscillate. For detecting the minimum value of an input current (Iin), the non-inverting input (-) is coupled to a clamp diode (D_{c}) which conducts a current when the input signal (Iin) is low i.e. the diode is ON. When the input signal (Iin) is high the current through the clamp diode is substantially zero i.e. the diode is OFF. The accuracy of detecting a minimum signal at the input depends on the commutation parameters of the clamp diode e.g. it's dynamic resistance and it's supply voltage. Unfortunately the dynamic resistance is frequency dependent and as a matter of consequence, the accuracy of the detector depends on the frequency of the input signal. Furthermore, the commutation parameters of the clamp diode deteriorate the edges of the input signal.

A controllable current source generates a current indicative for an approximation of the minimum signal value. This current has a parasitic component that further affects the accuracy of the minimum input signal indication.

It is therefore an object of the present invention to provide a minimum detector arrangement suitable to be used in high frequency systems.

The invention is defmed by the independent claims. The dependent claims define advantageous embodiments.

The minimum detector provides an output signal that is indicative for an approximation of the minimum value of an input signal. Depending on the minimum detector structure, the output signal is a more or less accurate indication on the minimum value of the input signal. In order to obtain a more accurate indication on the minimum value of the input signal the minimum signal detector arrangement further comprises a replica of the minimum signal detector for generating a second output signal that is indicative for an error in the approximation. The replica of the minimum detector has a hardware structure substantially identical to the minimum detector and is driven by an input signal that is indicative for the minimum value of the input signal. Said replica of the minimum detector generates the second output signal that is indicative for an error in the approximation. The first output signal is combined with the second output signal in a signal combination unit, said signal combination unit generating a third output signal indicative for a more accurate approximation of the minimum value of the input signal. If the error is additive i.e. there is an adding parasitic signal to the minimum value of the signal then the signal combination unit generates a signal indicative for a difference between the first output signal and the second output signal. If the error is subtractive i.e. there is a subtracting parasitic signal to the minimum value of the input signal then the signal combination unit generates a signal indicative for a sum between the first output signal and the second output signal. It is further observed that if the minimum detector arrangement has the first output signal and the second output signal as currents then the signal combination unit could be an electrical node where the currents could be subtracted or added directly depending on the error signal type i.e. additive or subtractive. In the case when the minimum detector arrangement has the first output signal and the second output signal as voltages the signal combination unit could be an adder or a subtractor depending on the error signal type i.e. subtractive or additive. If the minimum detector arrangement has the first output signal and the second output signal as frequencies then the signal combination unit could be digital counter or an analogue mixer, said mixer combining the first output signal and the second output signal and generating a complex signal indicative for the signals sum and difference. The mixer is coupled to a band-pass filter for selecting either the signal indicative for the difference of the signals, when the error is additive or the signal indicative for the sum of the signals, when the error is subtractive.

Because the minimum detector and the replica of the minimum detector are substantially identical then they are influenced in the same way by the environmental factors as power supply voltage and temperature. The minimum detector arrangement is then less sensitive to the variations in the environmental conditions.

In an embodiment of the invention the minimum detector and the replica of the minimum detector comprise a controllable clamp diode controlled by a control signal S, said clamp diode being coupled to an input for receiving the input signal and the other input signal, respectively. Normally a diode can be realized using a transistor. For example, if the transistor is a bipolar one then the diode could be realized by connecting the base to the collector, the resulting diode having a threshold voltage V_{BE} approximately equal to 0,65 volt if silicon transistors are considered. In order to improve the behavior of the transistor with high frequency signals the base of the transistor is connected to a control voltage that determines the current through the collector and as a matter of consequence the clamp diode better adapts to high frequency signals. In order to improve further the commutation behavior of the clamp diode there is provided an additional controllable diode coupled to an additional current source. The additional controllable diode is coupled to the clamp diode via a first resistor for minimizing a transition time of the clamp diode from a state ON to a state OFF. The state is considered ON when the current through the diode is different from zero and the state is considered OFF when the current through the diode is substantially zero. As a direct consequence, the edges of the signal obtained at the clamp diode are sharpened and when the clamp diode is coupled to a differential comparator said differential comparator has improved commutation characteristics e.g. avoiding an uncertainty situation when the input signals are considerably equal to each other for a relatively long period of time.

In order to further improve the commutation edges of the signal on the clamp diode it is provided a controllable reference diode coupled to a reference current source for generating a reference voltage. Said reference diode is further coupled to the additional controllable diode via a second resistor for minimizing a parasitic transition time of the clamp diode from a state ON to a state OFF. Said parasitic transition time is determined by the transition from a maximum value to a minimum value of the input signal.

The above and other features and advantages of the invention will be apparent from the following description of exemplary embodiments of the invention with reference to the accompanying drawings, in which:
Fig. 1 depicts a block diagram of a minimum current detector, as it is known in prior art,
Fig. 2 depicts a minimum detector arrangement according to the present invention,
Fig. 3 depicts an embodiment of the minimum detector arrangement of Fig. 2 in more detail,
Fig. 4 depicts a detailed description of a part of another embodiment of the minimum detector arrangement.

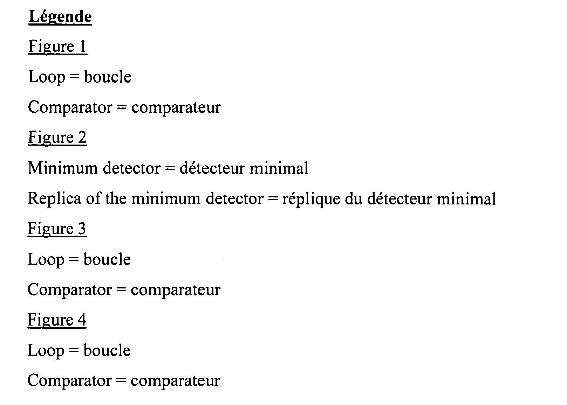

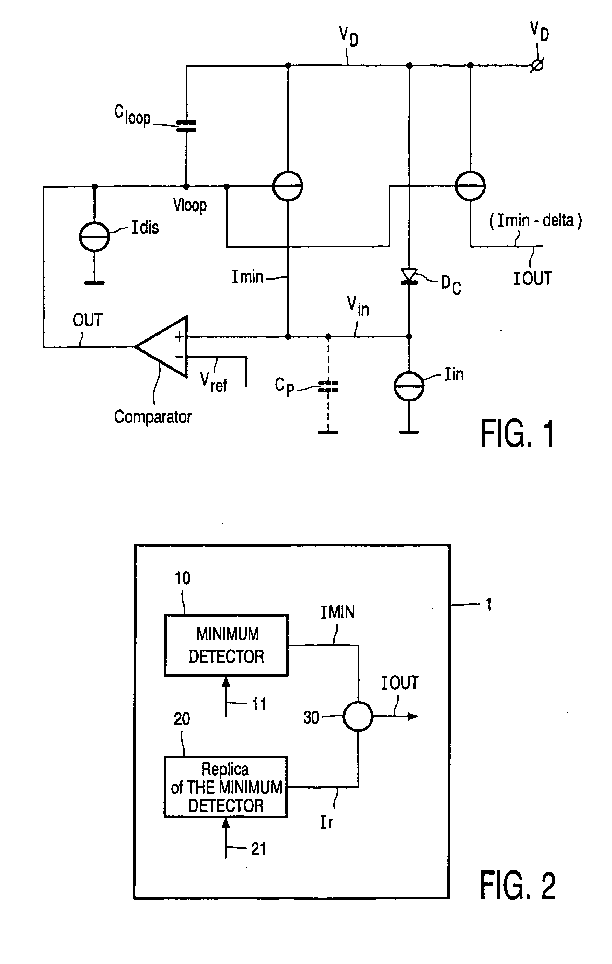

Fig. 1 depicts a block diagram of a minimum current detector, as it is known in prior art. The minimum current detector shown in Fig. 1 comprises a Comparator having a non-inverting input (+), an inverting input (-) and an output for providing a low level output signal OUT whenever a reference voltage Vref applied to the inverting input (-) is larger then a signal Vin applied to the non-inverting input (+). Otherwise the output signal OUT has a high level. In most applications the output signal OUT is a current. A clamp diode D_{C} is connected as a clamp diode for limiting the minimum value of the signal Vin. Iᵢₙ is an input current having two logical values i.e. a high value and a low value. The lowest value of Iᵢₙ must be determined using the minimum current detector. When Iᵢₙ is maximum the Vin is minimum and a voltage Vd on the clamp diode DC determines it. When the input signal Iᵢₙ is minimum i.e. Iₘᵢₙ, Vin is maximum. Then the clamp diode is substantially non-conducting i.e. it is OFF. The voltage Vin is further determined by a current Iₘᵢₙ-Idelta, Idelta being a residual current through the clamp diode. This current loads a parasitic capacitor Cₚ causing the voltage Vᵢₙ to rise. At the moment that the voltage Vin increases up to a level that is higher than V_{ref} the Comparator provides a current OUT that charges a capacitor C_{LOOP} and determines a voltage V_{LOOP} to be maintained as long as Iᵢₙ is minimum. At that moment the output current I_{OUT} is substantially equal to Iₘᵢₙ - Idelta. As it is seen, the output current is an approximation of the minimum value of the input current. Unfortunately there are several setbacks of this realization as are described further:
- depending on the speed of changing of the input current from it's minimum value to it's maximum value the value Idelta is variable.
- the clamp diode switches OFF a certain period of time after the input current switches from it's maximum value to it's minimum value i.e. with a certain time constant depending on it's characteristics. This further determines the voltage Vin to have a slow edge i.e. a slow rising time. This slow edge could determine instabilities in the comparator output signal OUT.
- the voltage Vin depends on environmental factors as power supply voltage and temperature.

Some of the above mentioned setbacks could be minimized using a minimum detector arrangement 1 as in Fig. 2 The minimum detector arrangement 1 comprises a minimum detector 10 for detecting a minimum value of an input signal 11 and generates a first output signal (Imin) indicative for an approximation of the minimum value of the input signal. The minimum detector arrangement 1 further comprises a replica of the minimum detector 20 for receiving another input signal 21 and generating a second output signal Ir indicative for an error in said approximation. The minimum detector 1 and the replica of the minimum detector 20 are coupled to a signal combination unit 30 for generating a third output signal Iout indicative for a more accurate approximation of the minimum value of the input signal 11.

The minimum detector 10 provides an output signal that is indicative for an approximation of the minimum value of an input signal 11. Depending on the minimum detector 10 structure, the output signal is a more or less accurate indication on the minimum value of the input signal 11. In order to obtain a more accurate indication on the minimum value of the input signal 11 the minimum signal detector arrangement 11 further comprises a replica of the minimum signal detector 20 for generating a second output signal Ir that is indicative for an error in the approximation. The replica of the minimum detector 20 has a hardware structure considerably identical to the minimum detector 10 being driven by an input signal 21 that is indicative for the minimum value of the input signal 11. Said replica of the minimum detector generates the second output signal Ir that is indicative for an error in the approximation. The first output signal Imin is coupled to the second output signal Ir in a signal coupler 30, said signal coupler 30 generating a third output signal Iout indicative for a more accurate approximation of the minimum value of the input signal 11. If the error is additive i.e. there is an adding parasitic signal to the minimum value of the signal then the signal combination unit generates a signal indicative for a difference between the first output signal and the second output signal. If the error is subtractive i.e. there is a subtracting parasitic signal to the minimum value of the input signal then the signal combination unit 30 generates a signal indicative for a sum between the first output signal min and the second output signal Ir. It is further observed that if the first output signal Imin and the second output signal Ir are currents then the signal combination unit 30 could be an electrical node. In this node the currents are subtracted from each other or added to each other depending on the error signal type i.e. additive or subtractive. In the case when the first output signal and the second output signal are voltages the signal combination unit 30 could be an adder or a subtractor depending on the error signal type i.e. subtractive or additive. If the first output signal Imin and the second output signal Ir are frequencies then the signal combination unit 30 could be a digital counter or an analogue mixer. The mixer combines the first output signal Iout and the second output signal Ir and generates a complex signal indicative for the signals sum and difference. The mixer is coupled to a band-pass filter for selecting either the signal indicative for the difference of the signals, when the error is additive or the signal indicative for the sum of the signals, when the error is subtractive.

Because the minimum detector 10 and the replica of the minimum detector 20 are substantially identical then they are influenced in the same way by the environmental factors as power supply voltage and temperature. As a matter of consequence the minimum detector arrangement 1 is then less sensitive to the variations in the environmental conditions. This influence could be further reduced if the minimum detector 10 and the replica of the minimum detector 20 are integrated on the same chip.

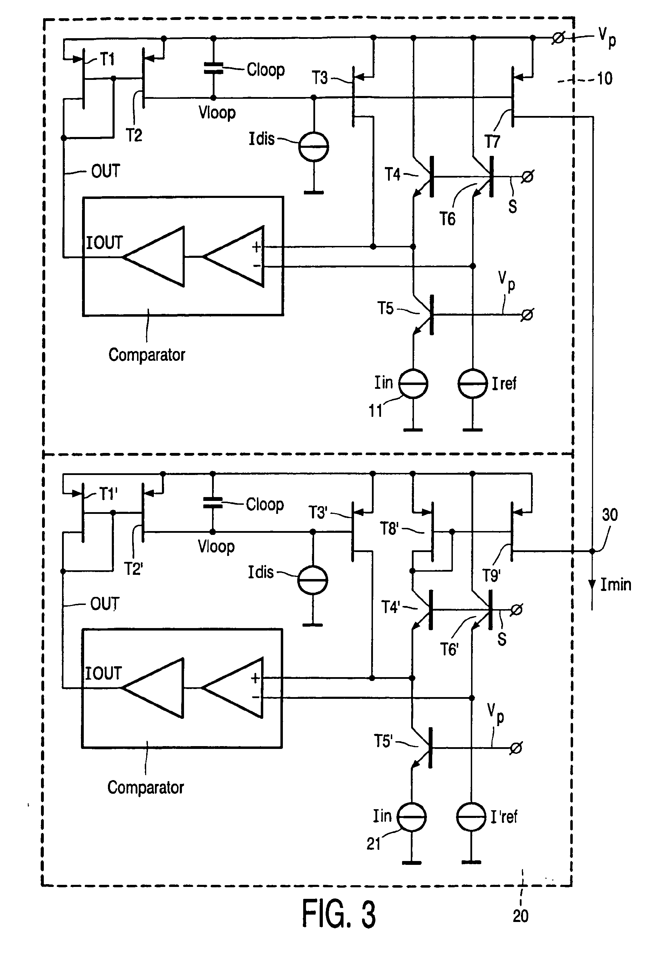

Fig. 3 depicts a minimum current detector with a replica of the minimum current detector according to an embodiment of the invention. In Fig. 3 the comparator could be of the same type as in Fig. 1. Transistors T1 and T2 realize a current source driven by the output of the comparator. When a magnitude of a signal applied at the non-inverting input of the comparator "+" is smaller that the magnitude of a signal applied at the inverting input of the comparator "-" the output signal OUT has a lower value and the capacitor Cloop is discharging. In a dual situation when the magnitude of the signal applied at the "+" input is larger than the magnitude of the signal applied at the inverting input the output of the comparator is at a high level. In this moment the capacitor Cloop charges causing a current in the drains of transistors T3 and T7. The drain currents of transistors T3 and T7 indicate the minimum current. Transistor T4 represents the clamp diode. Because of a residual current that exists in the clamp diode T4 when the minimum current is present at the input there will be a systematical error current affecting the minimum current indication, said error current being noted for convenience Idelta. The total current in the drain of the transistor T7 is Imin-Idelta, where Imin is the minimum current to be detected. A control signal S realizes a pre-polarization of the transistor T4 determining a smooth commutation i.e. with no overshoots. Transistor T5 is used in a so called "common base" connection it's base being connected to a DC signal Vp. The current source 11 is the input signal, said signal being a binary one i.e. having only a minimum and a maximum magnitude. Current source Iref and transistor T6 determines a reference voltage at the "-" input of the comparator. A replica of the minimum detector 20 is also presented in Fig. 3. All the components with similar functions as in minimum detector 10 have been noted as prime e.g. T3'. Transistors T8' and T9' realize a current source indicative for a minimum current in the clamp diode T4'. The current source 21 provides a predetermined current which is indicative for the minimum current. In the drain of the transistor T9' the current Idelta is generated and it is added in the node 30 to the minimum current obtained by the minimum current detector 10. In this way a better approximation of the minimum current is obtained. Furthermore, because the minimum detector 10 and the replica of the minimum detector 20 are normally integrated on the same chip, they are influenced in the same way by environmental factors as temperature and power supply voltage. As a matter of consequence the indication on Imin is considerably independent with respect said factors. It is further observed that the circuit presented in Fig. 3 is realized with p-MOS and bipolar NPN transistors. This does not exclude other possible combinations between different types of transistors realizing the same functions as in the above circuit that a person skilled in the art could find.

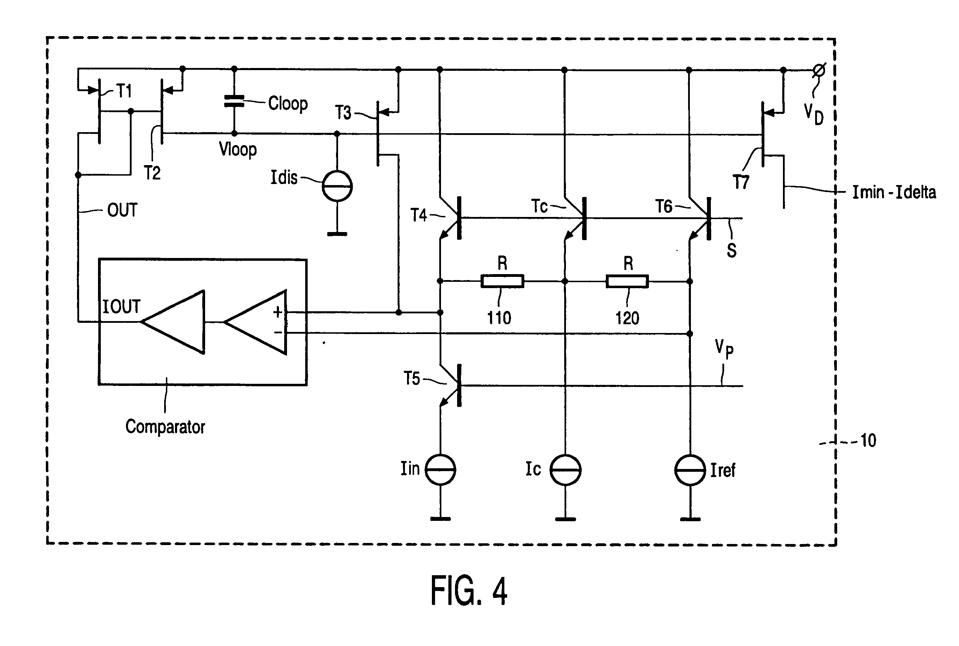

A very important issue when comparators are used is the shape of the input signals i.e. the voltage on the clamp diodes T4 and T4' in the minimum detector arrangement
1. Because comparators have an input off-set voltage when the differential input signal is comparable with the off-set voltage, uncontrollable output signals could appear at the output of the comparator. It is then desirable to have input signals with sharp edges. When the input signal commutes from a high to a low value the clamp diodes T4 and T4' commute from a state in which they conduct a current i.e. ON state to a state in which they do not conduct a current i.e. an OFF state. The transition from ON state to OFF state is not so sharp and takes some time. In order to sharpen this transition a transistor Tc driven by a current source Ic is provided as it is presented in Fig. 4. It should be pointed out that in Fig. 4 only the minimum detector 10 is presented but it is assumed that the replica of the minimum detector 20 has the same structure. The transistor Tc is connected as a controlled diode being controlled by the same signal S that controls the clamp diode D_{C}. A first resistor 110 realizes a first discharge path for the current of the clamp diode T4 when commuting from an ON state to an OFF state. This improves the commutation speed of the clamp diode T4 and as a matter of consequence improves the input signal edges. But, in the same time the commutation level i.e. the "-" input level of the comparator is influenced by the commutation of the clamp diode T4. That is why a second resistor 120 is connected between the Ic source and the Iref source. The transitions in the input signal Iin are further transferred at a certain scale to the "-" input of the comparator in such a manner that the comparison process is not influenced by the input signal transitions.

It is remarked that the scope of protection of the invention is not restricted to the embodiments described herein. Neither is the scope of protection of the invention restricted by the reference numerals in the claims. The word 'comprising' does not exclude other parts than those mentioned in a claim. The word 'a(n)' preceding an element does not exclude a plurality of those elements. Means forming part of the invention may both be implemented in the form of dedicated hardware or in the form of a programmed general-purpose processor.

## Claims

1. A minimum detector arrangement (1) comprising a minimum detector (10) generating a first output signal (Imin) indicative for an approximation of a minimum value of an input signal, **characterized in that** said minimum detector arrangement further comprises a replica of the minimum detector (20) for receiving another input signal (21) that is indicative for the approximation of the minimum value of the input signal and generating a second output signal (Ir) indicative for an error in said approximation, said minimum detector (10) and said replica of the minimum detector (20) being coupled to a signal combination unit (30) for generating a third output signal (Iout) indicative for a more accurate approximation of the minimum value of the input signal (11).

2. A minimum detector arrangement (1) as claimed in claim 1 wherein the signal combination unit (30) is conceived to add the first output signal (Imin) and the second output signal (Ir) to each other.

3. A minimum detector arrangement (1) as claimed in claim 1 wherein the signal combination unit (30) is conceived to subtract the first output signal (Imin) and the second output signal (Ir) to each other.

4. A minimum detector arrangement (1) as claimed in claim 1 wherein the input signal (11) and the other input signal (21) are currents.

5. A minimum detector arrangement (1) as claimed in claim 4 wherein the signal combination unit (30) is an electrical node.

6. A minimum detector arrangement (1) as claimed in claim 1 to 5 wherein the minimum detector (10) and the replica of the minimum detector (20) are integrated on a single chip.

7. A minimum detector arrangement (1) as claimed in Claim 5 wherein the minimum detector (10) and the replica of the minimum detector (20) comprise a controllable clamp diode (T4, T4') controlled by a control signal S, said clamp diode being coupled to an input for receiving the input signal (11) and the other input signal (21), respectively.

8. A minimum detector arrangement (1) as claimed in Claim 7 wherein the minimum detector (10) and the replica of the minimum detector (20) comprise an additional controllable diode (T_{C}) coupled to an additional current source (I_{C}), the additional controllable diode (T_{C}) being coupled to the clamp diode (T4) via a first resistor (110) for minimizing a transition time of the clamp diode from a state ON to a state OFF.

9. A minimum detector arrangement (1) as claimed in Claim 8 wherein the minimum detector (10) and the replica of the minimum detector (20) comprise a controllable reference diode (T6, T6') coupled to a reference current source (Iref) for generating a reference voltage (Vref), said reference diode (T6, T6')being further coupled to the additional controllable diode (T_{C})via a second resistor (120) for minimizing a parasitic transition time of the clamp diode from a state ON to a state OFF, said parasitic transition time being determined by a transition from a maximum value to a minimum value of the input signal (11).

## Patentansprüche

1. Minimum-Detektoranordnung (1), umfassend einen Minimum-Detektor (10), der ein erstes Ausgangssignal (Imin) erzeugt, das eine Näherung eines Minimalwerts eines Eingangssignals anzeigt, **dadurch gekennzeichnet, dass** diese Minimum-Detektoranordnung außerdem eine Replik des Minimum-Detektors (20) umfasst, um ein anderes Eingangssignal (21) zu empfangen, das die Näherung des Minimalwerts des Eingangssignals anzeigt und ein zweites Ausgangssignal (Ir) erzeugt, das einen Fehler in dieser Näherung anzeigt, wobei der Minimum-Detektor (10) und diese Replik des Minimum-Detektors (20) mit einer Signalkombinationseinheit (30) gekoppelt sind, um ein drittes Ausgangssignal (Iout) auszugeben, das eine genauere Näherung des Minimalwerts des Eingangssignals (11) anzeigt.

2. Minimum-Detektoranordnung (1) nach Anspruch 1, wobei die Signalkombinationseinheit (30) ausgelegt ist, um das erste Ausgangssignal (Imin) und das zweite Ausgangssignal (Ir) miteinander zu addieren.

3. Minimum-Detektoranordnung (1) nach Anspruch 1, wobei die Signalkombinationseinheit (30) ausgelegt ist, um das erste Ausgangssignal (Imin) und das zweite Ausgangssignal (Ir) voneinander zu subtrahieren.

4. Minimum-Detektoranordnung (1) nach Anspruch 1, wobei das Eingangssignal (11) und das andere Eingangssignal (21) Ströme sind.

5. Minimum-Detektoranordnung (1) nach Anspruch 4, wobei die Signalkombinationseinheit (30) ein elektrischer Knoten ist.

6. Minimum-Detektoranordnung (1) nach Anspruch 1 bis 5, wobei der Minimum-Detektor (10) und die Replik des Minimum-Detektors (20) auf einem einzigen Chip integriert sind.

7. Minimum-Detektoranordnung (1) nach Anspruch 5, wobei der Minimum-Detektor (10) und die Replik des Minimum-Detektors (20) eine steuerbare Klemmdiode (T4, T4') umfassen, die durch ein Steuersignal S gesteuert wird, wobei diese Klemmdiode mit einem Eingang zum jeweiligen Empfangen des Eingangssignals (11) und des anderen Eingangssignals (21) gekoppelt ist.

8. Minimum-Detektoranordnung (1) nach Anspruch 7, wobei der Minimum-Detektor (10) und die Replik des Minimum-Detektors (20) eine zusätzliche steuerbare Diode (Tc) umfassen, die mit einer zusätzlichen Stromquelle (Ic) gekoppelt ist, wobei die zusätzliche steuerbare Diode (Tc) über einen ersten Widerstand (110) mit der Klemmdiode (T4) gekoppelt ist, um eine Übergangszeit der Klemmdiode von einem Zustand EIN zu einem Zustand AUS zu minimieren.

9. Minimum-Detektoranordnung (1) nach Anspruch 8, wobei der Minimum-Detektor (10) und die Replik des Minimum-Detektors (20) eine steuerbare Bezugsdiode (T6, T6') umfassen, die mit einer Bezugsstromquelle (Iref) gekoppelt ist, um eine Bezugsspannung (Vref) zu erzeugen, wobei diese Bezugsdiode (T6, T6') außerdem über einen zweiten Widerstand (120) mit der zusätzlichen steuerbaren Diode (Tc) gekoppelt ist, um eine parasitäre Übergangszeit der Klemmdiode von einem Zustand EIN zu einem Zustand AUS zu minimieren, wobei diese parasitäre Übergangszeit durch einen Übergang von einem Maximalwert zu einem Minimalwert des Eingangssignals (11) bestimmt wird.

## Revendications

1. Montage de détecteur minimal (1) comprenant un détecteur minimal (10) qui génère un premier signal de sortie (Imin) étant indicatif d'une approximation d'une valeur minimale d'un signal d'entrée, **caractérisé en ce que** ledit montage de détecteur minimal comprend encore une réplique du détecteur minimal (20) pour recevoir un autre signal d'entrée (21) qui est indicatif de l'approximation de la valeur minimale du signal d'entrée et pour générer un deuxième signal de sortie (Ir) qui est indicatif d'une erreur de ladite approximation, ledit détecteur minimal (10) et ladite réplique du détecteur minimal (20) étant couplés à une unité de combinaison de signaux (30) pour générer un troisième signal de sortie (Iout) qui est indicatif d'une approximation plus précise de la valeur minimale du signal d'entrée (11).

2. Montage de détecteur minimal (1) selon la revendication 1, dans lequel l'unité de combinaison de signaux (30) est conçue de manière à additionner le premier signal de sortie (Imin) et le deuxième signal de sortie (Ir) l'un à l'autre.

3. Montage de détecteur minimal (1) selon la revendication 1, dans lequel l'unité de combinaison de signaux (30) est conçue de manière à soustraire le premier signal de sortie (Imin) et le deuxième signal de sortie l'un à l'autre.

4. Montage de détecteur minimal (1) selon la revendication 1, dans lequel le signal d'entrée (11) et l'autre signal d'entrée (21) sont des courants.

5. Montage de détecteur minimal (1) selon la revendication 4, dans lequel l'unité de combinaison de signaux (30) est un noeud électrique.

6. Montage de détecteur minimal (1) selon les revendications précédentes 1 à 5, dans lequel le détecteur minimal (10) et la réplique du détecteur minimal (20) sont intégrés sur une seule puce.

7. Montage de détecteur minimal (1) selon la revendication 5, dans lequel le détecteur minimal (10) et la réplique du détecteur minimal (20) comprennent une diode de limitation commandable (T4, T4') qui est commandée par un signal de commande S, ladite diode de limitation étant couplée à une entrée pour recevoir le signal d'entrée (11) et l'autre signal d'entrée (21), respectivement.

8. Montage de détecteur minimal (1) selon la revendication 7, dans lequel le détecteur minimal (10) et la réplique du détecteur minimal (20) comprennent une diode commandable additionnelle (T_{C}) qui est couplée à une source de courant additionnelle (I_{C}), la diode commandable additionnelle (T_{C}) étant couplée à la diode de limitation (T4) par le biais d'une première résistance (110) pour minimiser un temps de transition de la diode de limitation à partir d'un état non bloqué à un état bloqué.

9. Montage de détecteur minimal (1) selon la revendication 8, dans lequel le détecteur minimal (10) et la réplique du détecteur minimal (20) comprennent une diode de référence commandable (T6, T6') qui est couplée à une source de courant de référence (Iref) pour générer une tension de référence (Vref), ladite diode de référence (T6, T6') étant encore couplée à la diode commandable additionnelle (T_{C}) par le biais d'une deuxième résistance (120) pour minimiser un temps de transition parasite de la diode de limitation à partir d'un état non bloqué à un état bloqué, ledit temps de transition parasite étant déterminé par une transition à partir d'une valeur maximale à une valeur minimale du signal d'entrée (11).
